# EUROPEAN PATENT APPLICATION

(11) **EP 4 117 020 A1**
(43) Date of publication of application: **11.01.2023**
(21) Application number: 22182951.8
(22) Date of filing: 05.07.2022
(51) Int. Cl.: H01L 21/02, H01L 21/18, H01L 29/20, H01L 29/66, H01L 21/20

(54) **COMPOSITE SUBSTRATE AND PREPARATION METHOD THEREOF, SEMICONDUCTOR DEVICE, AND ELECTRONIC DEVICE**

(30) Priority: 06.07.2021 CN 202110762279
(71) Applicant: Huawei Technologies Co., Ltd., Shenzhen, Guangdong 518129, (CN)
(72) Inventor: Gao, Bo, Shenzhen, 518129 (CN); Huang, Boning, Shenzhen, 518129 (CN); Wan, Yuxi, Shenzhen, 518129 (CN)
(74) Representative: Thun, Clemens

(57) **Abstract**

Embodiments of this application relate to the field of semiconductor technologies, and provide a composite substrate and a preparation method thereof, a semiconductor device, and an electronic device, to resolve a problem of high costs of an AlxGayN-based semiconductor device due to high costs of SiC. The composite substrate includes a bearer layer, a silicon carbide layer, and at least one epitaxial layer. The silicon carbide layer is disposed on the bearer layer and bonded to the bearer layer, and a material of the silicon carbide layer includes monocrystal silicon carbide. The at least one epitaxial layer is disposed on a side that is of the silicon carbide layer and that is away from the bearer layer.

## Description

### TECHNICAL FIELD

This application relates to the field of semiconductor technologies, and in particular, to a composite substrate and a preparation method thereof, a semiconductor device, and an electronic device.

### BACKGROUND

Because an aluminum gallium nitrogen (AlₓGa_{y}N, x≥0, y≥0) material has excellent physical features such as a wide band gap, a high electron saturation speed, and a high critical breakdown field strength, the AlₓGa_{y}N material is usually used to manufacture a high-voltage and high-frequency device. On this basis, an AlₓGa_{y}N semiconductor device is widely applied infields such as aerospace, wireless communication, photoelectric conversion, and a charging adapter because of excellent features such as a high switching speed and small on resistance. However, the AlₓGa_{y}N material has no intrinsic crystal and has to be obtained by using a heteroepitaxy method. Therefore, an AlₓGa_{y}N heteroepitaxy technology becomes one of key technologies limiting the development of the AlₓGa_{y}N semiconductor device industry.

Currently, in the AlₓGa_{y}N semiconductor device, an AlₓGa_{y}N composite substrate has types such as laminated AlₓGa_{y}N and silicon carbide (SiC), laminated AlₓGa_{y}N and alumina (Al₂O₃), or laminated AlₓGa_{y}N and silicon (Si). Herein, SiC and AlₓGa_{y}N have a minimum lattice mismatch and a minimum thermal mismatch. Therefore, the AlₓGa_{y}N composite substrate that includes laminated AlₓGa_{y}N and SiC has low defect density, and therefore, becomes an ideal structure of the high-quality AlₓGa_{y}N composite substrate.

However, due to limitation on a growth manner and a yield of a SiC crystal, SiC has relatively high preparation costs. In this case, the composite substrate that includes laminated AlₓGa_{y}N and SiC has relatively high preparation costs, which limits wide application of the AlₓGa_{y}N semiconductor device in industrial and consumer products.

### SUMMARY

Embodiments of this application provide a composite substrate and a preparation method thereof, a semiconductor device, and an electronic device, to resolve a problem of high costs of an AlₓGa_{y}N semiconductor device due to high costs of SiC.

To achieve the foregoing objective, this application uses the following technical solutions.

According to a first aspect, a composite substrate is provided, including: a bearer layer; a silicon carbide layer, disposed on the bearer layer and bonded to the bearer layer, where a material of the silicon carbide layer includes monocrystal silicon carbide; and at least one epitaxial layer, disposed on a side that is of the silicon carbide layer and that is away from the bearer layer.

In a preparation method of a composite substrate provided in the embodiments of this application, a monocrystal silicon carbide ingot is cut in a hydrogen ion injection manner, to effectively reduce a cutting loss and improve a yield and cutting efficiency. In addition, the remaining monocrystal silicon carbide ingot after being polished may be still used as a monocrystal silicon carbide ingot. Therefore, in comparison with a monocrystal GaN substrate and a monocrystal SiC substrate, the composite substrate prepared by using the preparation method of a composite substrate provided in the embodiments of this application can improve utilization of the silicon carbide ingot and reduce the costs. In addition, a surface of the composite substrate provided in this embodiment of this application includes the epitaxial layer (III-V nitride). In comparison with another film layer grown on a non-monocrystal SiC substrate in a semiconductor device, when the another film layer in the semiconductor device is grown on the epitaxial layer of the composite substrate provided in this embodiment of this application, the silicon carbide layer and the epitaxial layer have a small lattice mismatch and a small thermal mismatch. Therefore, when the another film layer is grown on the epitaxial layer, defect density of the epitaxial layer is low, to meet a high-quality further epitaxy manufacturing requirement and a manufacturing requirement of the semiconductor device.

In a possible embodiment, the silicon carbide layer is bonded to the bearer layer in direct contact. In this way, a distance between the silicon carbide layer and the bearer layer is small, and thermal conductivity of the composite substrate is good.

In a possible embodiment, a thickness of a first bonding layer formed through bonding between the silicon carbide layer and the bearer layer in direct contact is less than or equal to 5 nm. An excessively large thickness of the first bonding layer affects thermal conductivity of the composite substrate.

In a possible embodiment, the composite substrate further includes a transition layer. The transition layer is located between the silicon carbide layer and the bearer layer. The silicon carbide layer and the bearer layer are separately bonded to the transition layer. The silicon carbide layer and the bearer layer are bonded by using the transition layer, to implement a good bonding effect and low bonding difficulty.

In a possible embodiment, the silicon carbide layer is bonded to the transition layer to form a second bonding layer, and the bearer layer is bonded to the transition layer to form a third bonding layer. A sum of the thickness of the transition layer, a thickness of the second bonding layer, and a thickness of the third bonding layer is less than or equal to 100 nm. An excessively large sum of the thickness of the transition layer, the thickness of the second bonding layer, and the thickness of the third bonding layer affects thermal conductivity of the composite substrate.

In a possible embodiment, a material of the epitaxial layer includes III-V nitride. The III-V nitride and the silicon carbide layer have a small lattice mismatch and a small thermal mismatch.

In a possible embodiment, the material of the silicon carbide layer includes 4H silicon carbide or 6H silicon carbide. Herein, the 4H or 6H silicon carbide and the epitaxial layer have a small thermal mismatch and a small lattice mismatch.

In a possible embodiment, a melting point of a material of the bearer layer is greater than or equal to 1260°C. In this way, the bearer layer can be prevented from being melted in an annealing processing process and being damaged in performance.

In a possible embodiment, a thickness of the silicon carbide layer is less than or equal to 350 µm, to avoid a waste of resources and an excessively large thickness of the composite substrate.

In a possible embodiment, a thickness of the bearer layer is less than or equal to 3000 µm, to avoid a waste of resources and an excessively large thickness of the composite substrate.

In a possible embodiment, a thickness of the at least one epitaxial layer is less than or equal to 3000 µm, to avoid a waste of resources and an excessively large thickness of the composite substrate.

According to a second aspect, a preparation method of a composite substrate is provided, including: performing hydrogen ion injection on a monocrystal silicon carbide ingot from a back surface of the monocrystal silicon carbide ingot, so that injected ions reach a preset depth; forming a defect layer at the preset depth; forming a silicon carbide layer on a side that is of the defect layer and that faces the back surface of the monocrystal silicon carbide ingot; bonding the back surface of the monocrystal silicon carbide ingot to a bearer layer to form a first composite structure; performing first annealing processing on the first composite structure, so that the silicon carbide layer is peeled off along the defect layer to form a second composite structure, where the second composite structure includes a damaged layer obtained through separation from the defect layer, and the silicon carbide layer and the bearer layer that are bonded to each other; performing surface processing on a surface that is of the silicon carbide layer and that is away from the bearer layer, and removing the damaged layer to form a third composite structure; performing second annealing processing on the third composite structure, and repairing a defect caused due to the hydrogen ion injection in the silicon carbide layer, where an annealing temperature of the second annealing processing is greater than a temperature of the first annealing processing; and forming at least one epitaxial layer on the surface that is of the silicon carbide layer and that is away from the bearer layer to form the composite substrate.

The composite substrate according to the first aspect can be obtained by using the preparation method of a composite substrate provided in this embodiment of this application. Beneficial effects of the method are the same as beneficial effects of the composite substrate. Details are not described herein again.

In a possible embodiment, before the performing second annealing processing on the third composite structure, the preparation method further includes: forming a carbon protective film on the surface that is of the silicon carbide layer and that is away from the bearer layer. Before the forming at least one epitaxial layer on the surface that is of the silicon carbide layer and that is away from the bearer layer, the preparation method further includes: removing the carbon protective film. The carbon protective film is formed on the surface that is of the silicon carbide layer and that is away from the bearer layer, to avoid carbon evaporation and silicon precipitation in the silicon carbide layer due to a high temperature in a subsequent high-temperature annealing process and therefore avoid roughness at the surface that is of the silicon carbide layer and that is away from the bearer layer.

In a possible embodiment, the bonding the back surface of the monocrystal silicon carbide ingot to a bearer layer includes: forming a transition layer on the back surface of the monocrystal silicon carbide ingot or the bearer layer; and bonding the back surface of the monocrystal silicon carbide ingot and the bearer layer by using the transition layer, where the composite substrate further includes the transition layer located between the silicon carbide layer and the bearer layer.

In a possible embodiment, the bonding the back surface of the monocrystal silicon carbide ingot to a bearer layer includes: bonding the back surface of the monocrystal silicon carbide ingot to the bearer layer in direct contact.

In a possible embodiment, a lattice direction of the monocrystal silicon carbide ingot is deflected in a range greater than or equal to 0° and less than or equal to 8° relative a <0001> lattice direction.

In a possible embodiment, energy of the hydrogen ion injection is greater than or equal to 100 keV, an injection dose is greater than or equal to 1e16 cm⁻², and an ion injection angle is in a range greater than or equal to 5° and less than or equal to 20°. In this way, the defect layer can be formed as an entire flat layer structure.

In a possible embodiment, the performing surface processing on a surface that is of the silicon carbide layer and that is away from the bearer layer, and removing the damaged layer includes: processing the surface that is of the silicon carbide layer and that is away from the bearer layer by using at least one of wet cleaning, plasma activation, high-temperature annealing, chemical mechanical polishing, mechanical polishing, reactive ion etching, ion beam etching, or ion beam grazing polishing, and removing the damaged layer.

In a possible embodiment, the temperature of the first annealing processing is greater than or equal to 1000°C, and the annealing temperature of the second annealing processing is greater than or equal to 1200°C.

In a possible embodiment, after the performing surface processing on a surface that is of the silicon carbide layer and that is away from the bearer layer, roughness at the surface that is of the silicon carbide layer and that is away from the bearer layer is less than or equal to 0.5 nm.

In a possible embodiment, an annealing environment of the first annealing processing is at least one of N₂, Ar, or H₂, and an annealing environment of the second annealing processing is at least one of vacuum, N₂, Ar, or a gas including C.

According to a third aspect, a semiconductor device is provided, including the composite substrate according to any one of the first aspect, and a heterojunction. The heterojunction is disposed on a side that is of at least one epitaxial layer of the composite substrate and that is away from the bearer layer.

According to a fourth aspect, an electronic device is provided, including the semiconductor device according to the third aspect, and an antenna. The semiconductor device is configured to amplify a radio frequency signal and output the amplified radio frequency signal to the antenna for external radiation.

According to a fifth aspect, an electronic device is provided, including the semiconductor device according to the third aspect, and a printed circuit board. The semiconductor device is coupled to the printed circuit board. A material of a bearer layer in the semiconductor device is a conductive material.

### BRIEF DESCRIPTION OF DRAWINGS

FIG. 1 is a schematic diagram of a structure of a base station according to an embodiment of this application;
FIG. 2 is a schematic diagram of a structure of an AAU according to an embodiment of this application;
FIG. 3Ais a schematic diagram of a structure of a charger according to an embodiment of this application;
FIG. 3B is a schematic diagram of a structure of a semiconductor device according to an embodiment of this application;
FIG. 3C is a schematic diagram of a structure of another semiconductor device according to an embodiment of this application;
FIG. 4 is a schematic diagram of a preparation procedure of a composite substrate according to an embodiment of this application;
FIG. 5A is a schematic flowchart of a preparation procedure of a composite substrate according to an embodiment of this application;
FIG. 5B is a schematic diagram of a preparation procedure of a composite substrate according to an embodiment of this application;
FIG. 6 is a diagram of a structure of a composite substrate according to an embodiment of this application;
FIG. 7A is a schematic flowchart of another preparation procedure of a composite substrate according to an embodiment of this application;
FIG. 7B is a schematic flowchart of another preparation procedure of a composite substrate according to an embodiment of this application;
FIG. 8A is a diagram of a structure of another composite substrate according to an embodiment of this application; and
FIG. 8B is a diagram of a structure of still another composite substrate according to an embodiment of this application.

### Reference numerals:

1: Base station; 2: Charger; 101: Baseband processing unit; 102: Active antenna unit; 121: Calculation unit; 122: First transmission unit; 123: Antenna unit; 1210: Control unit; 1211: Second transmission unit; 1212: Baseband unit; 1213: Power supply unit; 1221: RF unit; 1222: PA; 10: Monocrystal silicon carbide ingot; 11: Silicon carbide layer; 12: Remaining monocrystal silicon carbide ingot; 20: Defect layer; 21: Damaged layer; 30: Bearer layer; 41: First bonding layer; 42: Transition layer; 43: Second bonding layer; 44: Third bonding layer; 50: Carbon protective film; 60: Epitaxial layer; 100: Composite substrate; Q1: First composite structure; Q2: Second composite structure; Q3: Third composite structure

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise specified, "a plurality" of means two or more than two.

In the embodiments of this application, unless otherwise specified and limited, the term "electrical connection" may be direct electrical connection, or may be indirect electrical connection through an intermediate medium.

In addition, in embodiments of this application, the word "for example" is used to represent giving an example, an illustration, or a description. Any embodiment or design scheme described as "for example" in embodiments of this application should not be explained as being more preferred or having more advantages than another embodiment or design scheme. Exactly, use of the word "for example" or the like is intended to present a relative concept in a specific manner.

In embodiments of this application, "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects.

In the embodiments of this application, for example, on, under, left, right, front, and rear are relative direction indications used to explain structures and movement of different parts in this application. These indications are appropriate when the parts are in positions shown in the figure. However, if descriptions of the positions of the parts change, these direction indications correspondingly change.

In the embodiments of this application, the term "two-dimensional electron gas (two-dimensional electron gas, 2DEG)" indicates that movement of electrons perpendicular to an interface direction is bound by a potential well to quantize the electrons. Movement of electrons parallel to a surface is still free. In this case, free electrons in such a two-dimensional direction are referred to as the two-dimensional electron gas.

In the embodiments of this application, the term "back surface of a monocrystal silicon carbide ingot" indicates a (000-1) crystal orientation surface of the monocrystal silicon carbide ingot, and the term "front surface of a monocrystal silicon carbide ingot" indicates a (0001) crystal orientation surface of the monocrystal silicon carbide ingot.

In the embodiments of this application, the term "back surface of a silicon carbide layer" indicates a (000-1) crystal orientation surface of the silicon carbide layer, and the term "front surface of a silicon carbide layer" indicates a (0001) crystal orientation surface of the silicon carbide layer.

An embodiment of this application provides an electronic device. The electronic device may be, for example, different types of user equipment or terminal equipment such as a charger, a small-sized charging household electrical appliance (such as a soybean milk machine or a vacuum cleaning robot), an unmanned aerial vehicle, an aerospace device, a laser radar driver, a laser, a detector, a radar, and a 5G (the 5th generation mobile network, 5th generation mobile communication technology) communications device. The electronic device may alternatively be a network device such as a base station. A specific form of the electronic device is not specifically limited in the embodiments of this application.

A high electron mobility transistor (high electron mobility transistor, HEMT) device is a semiconductor device. The high electron mobility transistor is widely used as a radio frequency device or a power device because of advantages such as a high breakdown electric field, a high channel electron concentration, a high electron mobility, and high temperature stability.

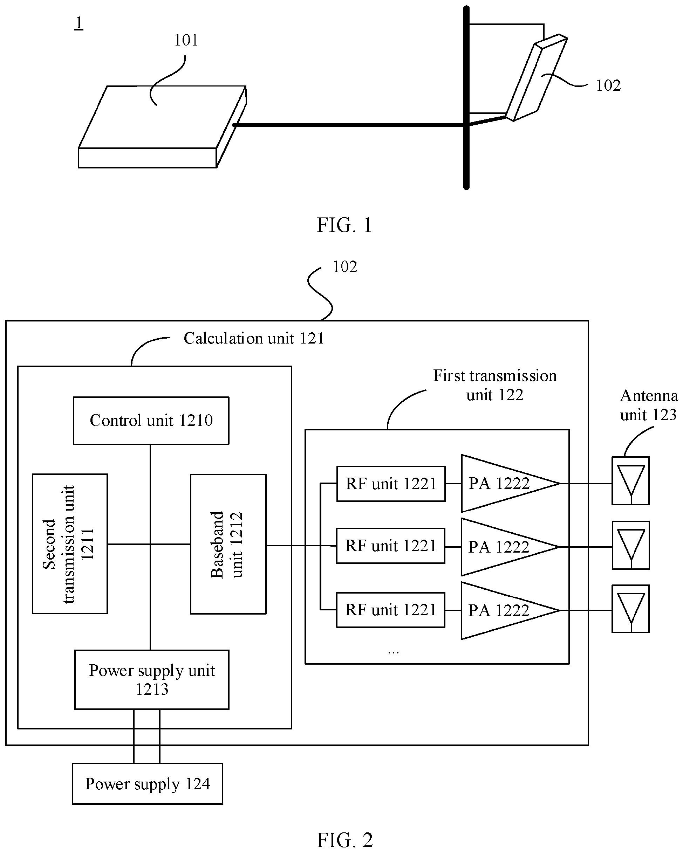

When the HEMT device is used as a radio frequency device, a structure of the electronic device is described by using an example in which the electronic device is a base station. As shown in FIG. 1, the base station 1 includes a baseband unit (baseband unit, BBU) 101 and an active antenna unit (active antenna unit, AAU) 102. The BBU 101 is mainly responsible for baseband digital signal processing, for example, FFT (fast Fourier transform, fast Fourier transform)/IFFT (inverse fast Fourier transform, inverse fast Fourier transform), modulation/demodulation, and channel coding/decoding. As shown in FIG. 2, the AAU 102 includes a calculation unit 121, a first transmission unit 122, and an antenna unit 123. The calculation unit 121 includes a control unit 1210, a second transmission unit 1211, a baseband unit 1212, and a power supply unit 1213. The control unit 1210, the second transmission unit 1211, the baseband unit 1212, and the power supply unit 1213 are electrically connected to each other. The control unit 1210 is configured to be responsible for control of a radio frequency signal. The second transmission unit 1211 is configured to be responsible for transmission of a radio frequency signal. The baseband unit 1212 is configured to be responsible for conversion between a digital signal and an analog signal. For example, the baseband unit 1212 is a DAC (digital to analog converter, digital-to-analog converter). The DAC may convert, to an analog signal, a digital signal output by the BBU 101. The power supply unit 1213 is electrically connected to a power supply 124, and is configured to supply power to the control unit 1210, the second transmission unit 1211, and the baseband unit 1212 in the calculation unit 121. The first transmission unit 122 is configured to be responsible for transmission and amplification of a radio frequency signal. The first transmission unit 122 includes an RF (radio frequency, radio frequency) unit 1221 and a PA (power amplifier, power amplifier) 1222. The RF unit 1221 is configured to convert an analog signal to a low-power radio frequency signal. The PA 1222 is configured to: amplify power of the low-power radio frequency signal, and output the amplified signal to the antenna unit 123. The antenna unit 123 is responsible for radiating a radio frequency signal. As shown in FIG. 2, the AAU 102 may include a plurality of RF units 1221, a plurality of PAs 1222, and a plurality of antenna units 123. It should be noted that the PA 1222 may be a HEMT device.

It should be understood that when the HEMT device is used as the PA, the electronic device provided in this embodiment of this application is not limited to the base stations shown in FIG. 1 and FIG. 2. Any electronic device that needs to be used to amplify a signal by using a power amplifier belongs to an application scenario of this embodiment of this application.

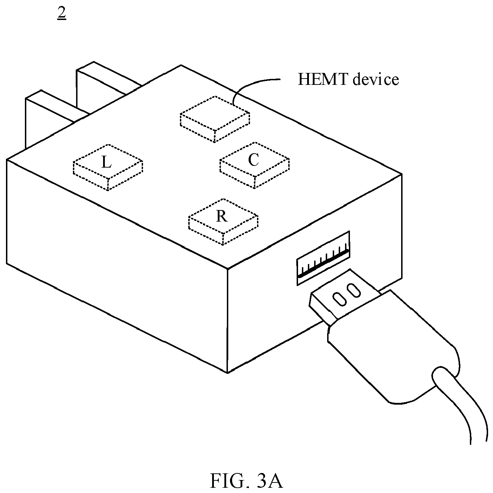

When the HEMT device is used as a power device, a structure of the electronic device is described by using an example in which the electronic device is a charger. As shown in FIG. 3A, a charger 2 may include a power device, a resistor R, an inductor L, a capacitor C, and the like. The power device may be, for example, a HEMT device. The HEMT device, the resistor R, the inductor L, and the capacitor C may be interconnected by using a printed circuit board (printed circuit board, PCB).

It should be understood that when the HEMT device is used as the power device, the electronic device provided in this embodiment of this application is not limited to the charger shown in FIG. 3A. Any electronic device that needs to use a power device belongs to an application scenario of this embodiment of this application.

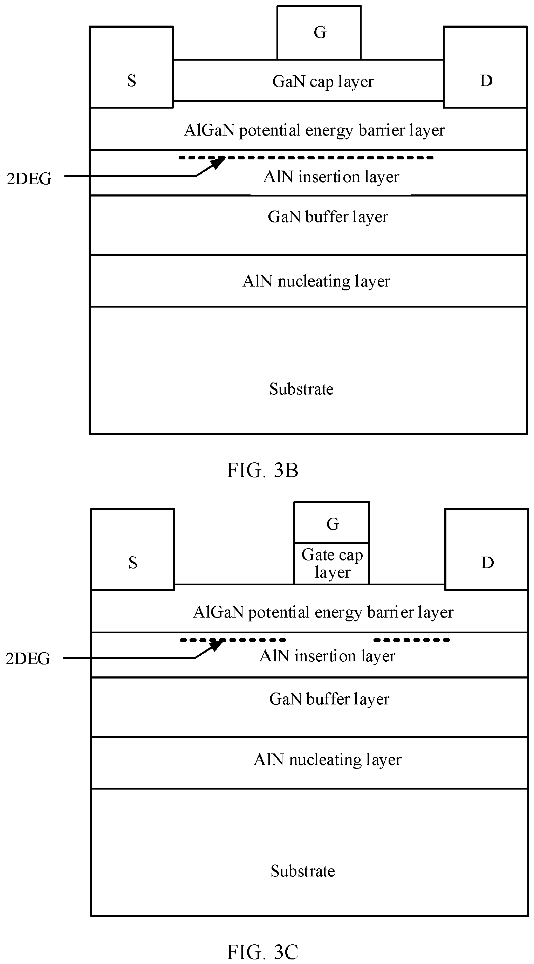

A structure of the HEMT device is used as an example. As shown in FIG. 3B, a normally open HEMT device includes a substrate; and an AlN (aluminum nitride) nucleating layer, a GaN (gallium nitride) buffer layer, an AlN insertion layer, an AlGaN (aluminum gallium nitrogen) potential energy barrier layer, a GaN cap layer, a source (source, S), a drain (drain, D), and a gate (gate, G) that are disposed on the substrate.

As shown in FIG. 3C, a normally closed HEMT device includes a substrate; and an AlN nucleating layer, a GaN buffer layer, an AlN insertion layer, an AlGaN potential energy barrier layer, a gate cap layer, a source (source, S), a drain (drain, D), and a gate (gate, G) that are disposed on the substrate.

The gate cap layer may adjust an energy band structure, to exhaust electrons below the gate cap layer. The 2DEG is in an off state without bias voltage. The 2DEG cannot flow at a channel layer between the source S and the drain D. The HEMT device is in an off state.

A working principle of the HEMT device is as follows: The source S and the drain D are separately in conductive ohmic contact with the AlGaN potential energy barrier layer. The gate G is in Schottky contact with the AlGaN potential energy barrier layer. A dashed line in the AlN insertion layer represents the 2DEG generated due to a polarization function in a heterojunction formed by the AlN insertion layer and the AlGaN potential energy barrier layer in the HEMT device. The 2DEG is used to efficiently conduct electrons under a function of an electric field. The source S and the drain D are configured to enable the 2DEG to flow at the AlN insertion layer between the source S and the drain D under the function of the electric field. The conduction between the source S and the drain D occurs at the two-dimensional electron gas at the AlN insertion layer. The gate G is disposed between the source S and the drain D to allow or hinder passing of the two-dimensional electron gas. The 2DEG has high conductivity, partly because electrons are trapped in a very small region at an interface between the AlN insertion layer and the AlGaN potential energy barrier layer, to greatly improve an electron mobility.

When the HEMT device serves as a radio frequency device, the substrate in the HEMT device is a non-conductive substrate. When the HEMT device serves as a power device, the substrate in the HEMT device is a conductive substrate.

Because an aluminum gallium nitrogen (AlₓGa_{y}N, x≥0, y≥0) material has excellent physical features such as a wide band gap, a high electron saturation speed, and a high critical breakdown field strength, the AlₓGa_{y}N material is usually used to manufacture a high-voltage and high-frequency device. On this basis, an AlₓGa_{y}N semiconductor device is widely applied in fields such as aerospace, wireless communication, photoelectric conversion, and a charging adapter because of excellent features such as a high switching speed and small on resistance.

Herein, because silicon carbide (SiC) has relatively high costs, in the power device, the AlₓGa_{y}N composite substrate that includes laminated AlₓGa_{y}N and SiC has relatively high costs, which severely limits wide application of the AlₓGa_{y}N semiconductor device in industrial and consumer products.

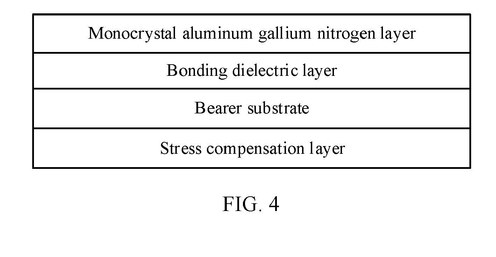

To resolve the foregoing problem, a preparation method of a composite substrate is provided. A monocrystal GaN layer is first epitaxially grown on a sapphire substrate. Then, the monocrystal GaN layer is bonded to a bearer substrate on which a stress compensation layer is formed. Afterwards, the sapphire substrate is peeled off to obtain a composite substrate shown in FIG. 4. As shown in FIG. 4, the composite substrate includes a bearer substrate; a bonding dielectric layer and a monocrystal GaN layer that are located on the bearer substrate; and a stress compensation layer on a back surface of the bearer substrate.

Although the composite substrate shown in FIG. 4 has the advantages of the GaN substrate, growing the monocrystal GaN layer on the sapphire substrate still faces problems such as high technical complexity, a large growth thickness, and a low yield. Therefore, it is difficult to obtain the composite substrate. In addition, the costs are high. Further, the stress compensation layer is a thin film dielectric layer, and has poor stability in a subsequent processing process, thereby causing stress aggravation or release. Consequently, a newly grown epitaxial layer has high defect density, and the monocrystal GaN layer is even peeled off or fragmented.

On this basis, an embodiment of this application further provides a preparation method of a composite substrate. An AlxGayN device with low defect density can be directly prepared by using a composite substrate prepared by using the preparation method of a composite substrate. The composite substrate has low preparation costs, thereby improving popularization and application of the AlxGayN semiconductor device in various fields.

The following describes the preparation method of a composite substrate provided in this embodiment of this application by using several examples.

### Example 1

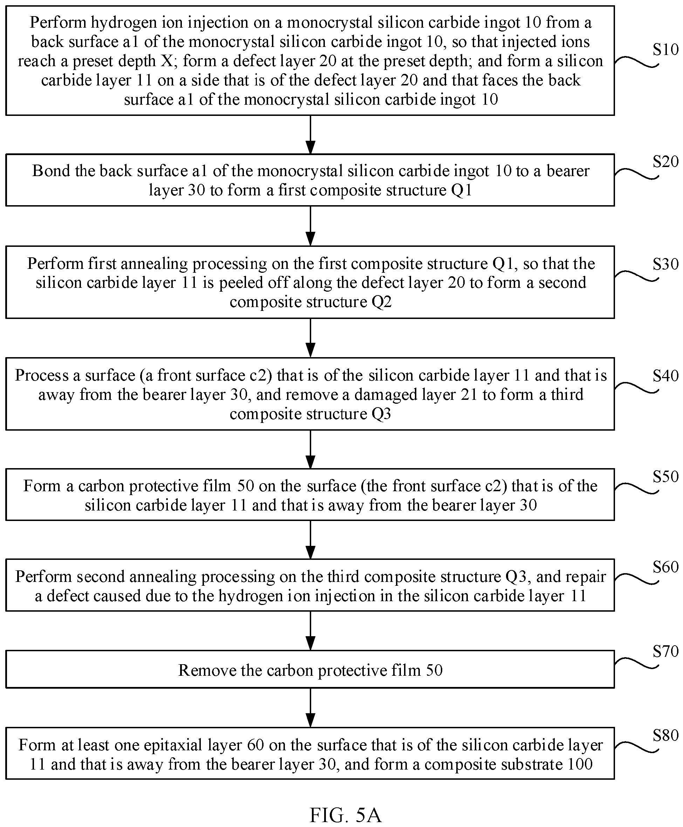

As shown in FIG. 5A, an embodiment of this application provides a preparation method of a composite substrate. The method includes the following steps:

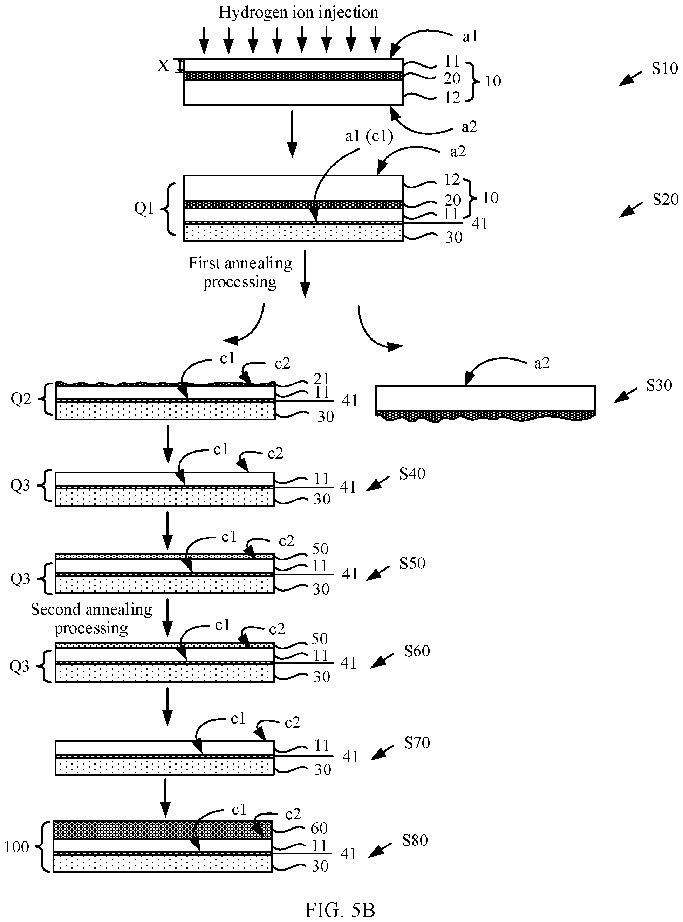

S10: As shown in FIG. 5B, perform hydrogen ion injection on a monocrystal silicon carbide ingot 10 from a back surface a1 of the monocrystal silicon carbide ingot 10, so that injected ions reach a preset depth X; form a defect layer 20 at the preset depth; and form a silicon carbide layer 11 on a side that is of the defect layer 20 and that faces the back surface a1 of the monocrystal silicon carbide ingot 10.

In other words, a part, in the monocrystal silicon carbide ingot 10, located on the side that is of the defect layer 20 and that faces the back surface a1 of the monocrystal silicon carbide ingot 10 is used as the silicon carbide layer 11.

In some embodiments, a lattice direction of the monocrystal silicon carbide ingot 10 is deflected in a range greater than or equal to 0° and less than or equal to 8° relative a <0001> lattice direction.

For example, the lattice direction of the monocrystal silicon carbide ingot 10 is not deflected (deflected by 0°) relative to the <0001> lattice direction; the lattice direction of the monocrystal silicon carbide ingot 10 is deflected by 1° relative to the <0001> lattice direction; the lattice direction of the monocrystal silicon carbide ingot 10 is deflected by 2° relative to the <0001> lattice direction; the lattice direction of the monocrystal silicon carbide ingot 10 is deflected by 3° relative to the <0001> lattice direction; the lattice direction of the monocrystal silicon carbide ingot 10 is deflected by 4° relative to the <0001> lattice direction; the lattice direction of the monocrystal silicon carbide ingot 10 is deflected by 5° relative to the <0001> lattice direction; the lattice direction of the monocrystal silicon carbide ingot 10 is deflected by 6° relative to the <0001> lattice direction; and the lattice direction of the monocrystal silicon carbide ingot 10 is deflected by 7° relative to the <0001> lattice direction.

In this way, a lattice direction of the silicon carbide layer 11 obtained by using the monocrystal silicon carbide ingot 10 is also deflected in the range greater than or equal to 0° and less than or equal to 8° relative to the <0001> lattice direction. The silicon carbide layer 11 and the epitaxial layer have a small lattice mismatch. Therefore, defect density of epitaxial growth can be reduced during the subsequent epitaxial growth at a surface of the silicon carbide layer 11.

In some embodiments, to form the entire flat defect layer 20, energy of the hydrogen ion injection is greater than or equal to 100 keV. In some embodiments, a dose of the hydrogen ion injection is greater than or equal to 1e16 cm². In some embodiments, an angle of the hydrogen ion injection is in a range greater than or equal to 5° and less than or equal to 20°. For example, the angle of the hydrogen ion injection is 10° or 15°. A structure form of the defect layer 20 may be adjusted through adjusting the energy, the dose, and the angle of the hydrogen ion injection.

In other words, the defect layer 20 is formed at the preset depth X of the monocrystal silicon carbide ingot 10 through the hydrogen ion injection. The defect layer 20 divides the monocrystal silicon carbide ingot 10 into two parts. Apart located on a side that is of the defect layer 20 and that is near the back surface a1 of the monocrystal silicon carbide ingot 10 is used as the silicon carbide layer 11, and a part located on a side that is of the defect layer 20 and that is away from the back surface a1 of the monocrystal silicon carbide ingot 10 (close to a front surface a2 of the monocrystal silicon carbide ingot 10) is used as the remaining monocrystal silicon carbide ingot 12.

The remaining monocrystal silicon carbide ingot 12 after being polished may be used as the monocrystal silicon carbide ingot 10 in a next time of manufacturing the composite substrate. Certainly, if a thickness of the remaining monocrystal silicon carbide ingot 12 may be exactly used as the silicon carbide layer 11, the remaining monocrystal silicon carbide ingot 12 may be directly used as the silicon carbide layer 11.

A thickness of the silicon carbide layer 11 may be adjusted through adjusting the preset depth X. In a hydrogen ion injection process, the energy of the hydrogen ion injection may be adjusted to enable injected ions to reach the preset depth X.

In some embodiments, the energy of the hydrogen ion injection is adjusted, so that the thickness of the silicon carbide layer 11 is less than or equal to 350 µm.

For example, the thickness of the silicon carbide layer 11 is 300 µm, 250 µm, 200 µm, 150 µm, or 100 µm.

In some embodiments, a material of the monocrystal silicon carbide ingot 10 includes 4H silicon carbide or 6H silicon carbide. In this way, a material of the silicon carbide layer 11 prepared by using the monocrystal silicon carbide ingot 10 also includes 4H silicon carbide or 6H silicon carbide. When an epitaxial layer is subsequently formed on the surface of the silicon carbide layer 11, the silicon carbide layer 11 and the epitaxial layer have a small lattice mismatch. The epitaxial layer has low defect density.

In some embodiments, the back surface a1 of the monocrystal silicon carbide ingot 10 is disposed opposite to the front surface a2 of the monocrystal silicon carbide ingot 10. The back surface a1 of the monocrystal silicon carbide ingot 10 and the front surface a2 of the monocrystal silicon carbide ingot 10 have the same roughness requirement.

S20: As shown in FIG. 5B, bond the back surface a1 of the monocrystal silicon carbide ingot 10 to a bearer layer 30 to form a first composite structure Q1.

In some embodiments, a thickness of the bearer layer 30 is less than or equal to 3000 µm.

For example, the thickness of the bearer layer 30 is 2500 µm, 2000 µm, 1500 µm, 1000 µm, or 500 µm.

The bearer layer 30 has a support function for the monocrystal silicon carbide ingot 10. The excessively large thickness of the bearer layer 30 causes a waste of resources and increases the thickness of the composite substrate.

When the composite substrate is prepared, there are two high-temperature annealing processes in a subsequent preparation process. A second annealing processing temperature is greater than a first annealing processing temperature.

On this basis, in some embodiments, to avoid a change of a form of the bearer layer 30 in a subsequent annealing processing process, a melting point of a material of the bearer layer 30 is greater than the second annealing processing temperature. For example, the melting point of the material of the bearer layer 30 is greater than or equal to 1260°C.

In some embodiments, the material of the bearer layer 30 includes a conductive substrate such as Si (silicon) or SiC (silicon carbide); an insulating substrate such as SiO₂ (silicon oxide), Si₃N₄ (silicon nitride), Al₂O₃ (alumina); or a composite multi-layer substrate including the foregoing plurality of materials. The foregoing materials may be a monocrystal structure, a polycrystal structure, or an amorphous structure.

When the material of the bearer layer 30 is a conductive substrate, the composite substrate is a conductive substrate. When the material of the bearer layer 30 is an insulating substrate, the composite substrate is an insulating substrate. Therefore, the material of the bearer layer 30 is selected, so that a HEMT device using the composite substrate can be used as a radio frequency device or a power device.

In some embodiments, the back surface a1 of the monocrystal silicon carbide ingot 10 is directly bonded to the bearer layer 30 in direct contact.

In other words, the back surface a1 of the monocrystal silicon carbide ingot 10 faces the bearer layer 30, and the monocrystal silicon carbide ingot 10 is bonded to the bearer layer 30 in direct contact.

It may be understood that the silicon carbide layer 11 is obtained from the monocrystal silicon carbide ingot 10. The back surface a1 of the monocrystal silicon carbide ingot 10 is also a back surface c1 of the silicon carbide layer 11. Therefore, the back surface a1 of the monocrystal silicon carbide ingot 10 is bonded to the bearer layer 30 in direct contact. In other words, the back surface a1 of the silicon carbide layer 11 is bonded to the bearer layer 30 in direct contact. In the prepared composite substrate, the silicon carbide layer 11 is bonded to the bearer layer 30 in direct contact.

For example, surface cleaning and surface processing are performed on the back surface a1 of the monocrystal silicon carbide ingot 10 and the bearer layer 30, and then the back surface a1 of the monocrystal silicon carbide ingot 10 is bonded to the bearer layer 30 in direct contact.

A manner of performing the surface processing on the back surface a1 of the monocrystal silicon carbide ingot 10 and the bearer layer 30 may include, for example, at least one of wet cleaning, activation, chemical activation, plasma activation, and metal deposition.

In addition, bonding the back surface a1 of the monocrystal silicon carbide ingot 10 to the bearer layer 30 in direct contact may be performed in an environment such as a normal temperature, a high temperature, high pressure, normal pressure, or vacuum. This is not limited in this embodiment of this application.

It may be understood that a first bonding layer 41 is naturally formed in a process of bonding the back surface a1 of the monocrystal silicon carbide ingot 10 to the bearer layer 30 in direct contact. A thickness of the first bonding layer 41 may be controlled through controlling a time in which the back surface a1 of the monocrystal silicon carbide ingot 10 is bonded to the bearer layer 30.

In some embodiments, the thickness of the first bonding layer 41 is less than or equal to 5 nm. For example, the thickness of the first bonding layer 41 is 1 nm, 2 nm, 3 nm, or 4 nm.

An excessively large thickness of the first bonding layer 41 affects thermal conductivity of the composite substrate. Therefore, the thickness of the first bonding layer 41 is controlled to be less than or equal to 5 nm, to reduce the thickness of the first bonding layer 41 as much as possible on the basis of ensuring that the back surface a1 of the monocrystal silicon carbide ingot 10 is bonded to the bearer layer 30 in direct contact.

On this basis, it may be understood that the first composite structure Q1 includes the monocrystal silicon carbide ingot 10, the first bonding layer 41, and the bearer layer 30.

S30: As shown in FIG. 5B, perform first annealing processing on the first composite structure Q1, so that the silicon carbide layer 11 is peeled off along the defect layer 20 to form a second composite structure Q2.

The second composite structure Q2 includes a damaged layer 21 obtained through separation from the defect layer 20, and the silicon carbide layer 11 and the bearer layer 30 that are bonded. The damaged layer 21 is located on a surface that is of the silicon carbide layer 11 and that is away from the bearer layer 30 (a front surface c2 of the silicon carbide layer 11).

First annealing processing is performed on the first composite structure Q1. For example, the first composite structure Q1 may be processed by using a thermal annealing process.

In some embodiments, an annealing temperature at which the first annealing processing is performed on the first composite structure Q1 may be, for example, greater than or equal to 1000°C. For example, the annealing temperature of the first annealing processing is 1050°C, 1100°C, or 1150°C.

In some embodiments, an annealing environment in which the first annealing processing is performed on the first composite structure Q1 may be at least one of N₂ (nitrogen), Ar (argon), or H₂ (hydrogen).

An annealing time of the first annealing processing is not limited in this embodiment of this application, and is reasonably determined based on factors such as the thickness of the defect layer 20, so that the defect layer 20 can be naturally cracked to obtain the second composite structure Q2.

S40: As shown in FIG. 5B, process a surface (the front surface c2) that is of the silicon carbide layer 11 and that is away from the bearer layer 30, and remove the damaged layer 21 to form a third composite structure Q3.

In some embodiments, the surface (the front surface c2) that is of the silicon carbide layer 11 and that is away from the bearer layer 30 is processed by using one or more processes such as wet cleaning, plasma activation, high-temperature annealing, CMP, CP, mechanical polishing, reactive ion etching, ion beam etching, or ion beam grazing polishing, to remove the damaged layer 21.

It may be understood that the surface (the front surface c2) that is of the silicon carbide layer 11 and that is away from the bearer layer 30 may be processed to remove the damaged layer 21. The obtained third composite structure Q3 includes the silicon carbide layer 11 and the bearer layer 30 that are bonded (for example, the silicon carbide layer 11, the first bonding layer 41, and the bearer layer 30).

In some embodiments, a process of processing the surface (the front surface c2) that is of the silicon carbide layer 11 and that is away from the bearer layer 30 includes at least one or more of CMP, CP, and mechanical polishing, to reduce roughness at the surface (the front surface c2) that is of the silicon carbide layer 11 and that is away from the bearer layer 30.

In some embodiments, after the surface processing is performed on the surface that is of the silicon carbide layer 11 and that is away from the bearer layer 30, roughness at the surface that is of the silicon carbide layer 11 and that is away from the bearer layer 30 is less than or equal to 0.5 nm.

In other words, the roughness at the front surface c2 of the silicon carbide layer 11 is less than or equal to 0.5 nm, to meet a requirement for the roughness at the front surface c2 of the silicon carbide layer 11 when the epitaxial layer is formed on the front surface c2 of the silicon carbide layer 11.

S50: As shown in FIG. 5B, form a carbon protective film 50 on the surface (the front surface c2) that is of the silicon carbide layer 11 and that is away from the bearer layer 30.

For example, the carbon protective film 50 may be formed on the surface (the front surface c2) that is of the silicon carbide layer 11 and that is away from the bearer layer 30 by using a sputtering process.

Resources are wasted if a thickness of the carbon protective film 50 is excessively large. A protection function is not implemented if the thickness of the carbon protective film 50 is excessively small. In some embodiments, the thickness of the carbon protective film 50 is 10 nm to 50 nm. For example, the thickness of the carbon protective film 50 is 20 nm, 25 nm, 30 nm, 35 nm, or 40 nm.

The carbon protective film 50 is formed on the surface (the front surface c2) that is of the silicon carbide layer 11 and that is away from the bearer layer 30, to avoid carbon evaporation and silicon precipitation in the silicon carbide layer 11 due to a high temperature in a subsequent high-temperature annealing process and therefore avoid roughness at the surface (the front surface c2) that is of the silicon carbide layer 11 and that is away from the bearer layer 30.

S60: As shown in FIG. 5B, perform second annealing processing on the third composite structure Q3, and repair a defect caused due to hydrogen ion injection in the silicon carbide layer 11.

It may be understood that, when the carbon protective film 50 is formed on the surface (the front surface c2) that is of the silicon carbide layer 11 and that is away from the bearer layer 30. In other words, when the preparation method of a composite substrate includes step S50, the second annealing processing is performed on the third composite structure Q3, that is, processing is performed on a structure in which the carbon protective film 50 covers the surface of the third composite structure Q3.

The second annealing processing is performed on the third composite structure Q3. For example, the third composite structure Q3 may be processed by using a thermal annealing process. The annealing temperature of the second annealing processing is greater than the annealing temperature of the first annealing processing.

In some embodiments, an annealing temperature at which the second annealing processing is performed on the third composite structure Q3 may be, for example, greater than or equal to 1200°C. For example, the annealing temperature of the second annealing processing is 1250°C, 1300°C, 1350°C, or 1400°C.

In some embodiments, an annealing environment in which the second annealing processing is performed on the third composite structure Q3 is at least one of atmospheric pressure, vacuum, N₂, Ar, or a gas including C (carbon).

This embodiment of this application does not limit the annealing time of the second annealing processing, provided that a defect caused due to hydrogen ion injection in the silicon carbide layer 11 can be repaired. In addition, the defect repair herein may be fully repair or repair to a certain extent, provided that processing is performed according to actual requirements.

S70: As shown in FIG. 5B, remove the carbon protective film 50.

For example, the carbon protective film 50 may be removed through high temperature oxidation or a plasma processing process.

It should be noted that in some embodiments, the preparation method of a composite substrate does not include step S50. In other words, before the second annealing processing is performed on the third composite structure Q3, the carbon protective film 50 is not formed, and the second annealing processing is directly performed on the third composite structure Q3. In this way, the preparation method of a composite substrate does not include step S70.

S80: As shown in FIG. 5B, form at least one epitaxial layer 60 on the surface that is of the silicon carbide layer 11 and that is away from the bearer layer 30, and form a composite substrate 100.

For example, one or more epitaxial layers 60 may be formed by using a process such as a metal-organic chemical vapor deposition (metal-organic chemical vapor deposition, MOCVD) growth method or a molecular beam epitaxy (molecular beam epitaxy, MBE) growth method. Materials of the plurality of epitaxial layers 60 may be the same, may be different, or may be not fully the same.

In some embodiments, a material of the epitaxial layer 60 includes III-V nitride.

For example, the material of the epitaxial layer 60 includes AlₓGa_{y}N (x≥0, y≥0).

For example, an AlN epitaxial layer, or a GaN epitaxial layer, or an AlGaN epitaxial layer, or a plurality of nitride epitaxial layers is/are formed on the surface that is of the silicon carbide layer 11 and that is away from the bearer layer 30.

In some embodiments, a sum of a thickness of the at least one epitaxial layer 60 is less than or equal to 3000 µm.

The sum of the thickness of the at least one epitaxial layer 60 may be understood as follows: When the epitaxial layer 60 is formed on the surface that is of the silicon carbide layer 11 and that is away from the bearer layer 30, the thickness of the epitaxial layer 60 is less than or equal to 3000 µm. When the plurality of epitaxial layers 60 are formed on the surface that is of the silicon carbide layer 11 and that is away from the bearer layer 30, the sum of the thicknesses of the plurality of epitaxial layers 60 is less than or equal to 3000 µm.

For example, the sum of the thickness of the at least one epitaxial layer 60 is 2500 µm, 2000 µm, 1500 µm, 1000 µm, 500 µm, 400 µm, 300 µm, 200 µm, 100 µm, 90 µm, 80 µm, 70 µm, 60 µm, 50 µm, 40 µm, 30 µm, 20 µm, 10 µm, 9 µm, 8 µm, 7 µm, 6 µm, 5 µm, 4 µm, 3 µm, 2 µm, or 1 µm.

An excessively large thickness of the bearer layer 30 causes a waste of resources and increases the thickness of the composite substrate.

The following describes an example of the preparation method of a composite substrate provided in this example by using two specific embodiments.

The preparation method of a composite substrate includes:
Hydrogen ions (H+) are injected to the back surface of the non-conductive 4H monocrystal silicon carbide ingot 10 in the <0001> lattice direction. The defect layer 20 is formed at a position of the preset depth X of the back surface.

The temperature of the hydrogen ion injection is a room temperature. The energy of the hydrogen ion injection is 100 keV. The dose of the hydrogen ion injection is 1e17 cm². The angle of the hydrogen ion injection is 7°.

Chemical liquid cleaning and drying are performed on the back surface of the monocrystal silicon carbide ingot 10 and a Si₃N₄ substrate (the bearer layer 30). Then, plasma activation is performed on the back surface a1 of the monocrystal silicon carbide ingot 10 and the Si₃N₄ substrate by using Ar, N₂, O₂ (oxygen), or the like. Afterwards, the back surface a1 of the monocrystal silicon carbide ingot 10 is directly bonded to the Si₃N₄ substrate in direct contact in a vacuum environment of 200°C and 10⁻⁴ mbar. The first composite structure Q1 is formed.

Bonding pressure is 10 kN. A bonding time is 120 min.

The first composite structure Q1 is placed in a high-temperature annealing furnace. In a N₂ protection environment, the first composite structure Q1 is heated to 1000°C at a rate of 20°C/s, then is annealed for 60 min, and is cooled and taken out of the furnace. The monocrystal silicon carbide ingot 10 is automatically peeled off along the defect layer 20 to form the second composite structure Q2.

The second composite structure Q2 includes the damaged layer 21 obtained through separation from the defect layer 20, and the silicon carbide layer 11 and the bearer layer 30 that are bonded. The damaged layer 21 is located on the surface that is of the silicon carbide layer 11 and that is away from the bearer layer 30. The remaining monocrystal silicon carbide ingot 12 whose surface after the peeling is polished may be used as the monocrystal silicon carbide ingot 10 for manufacturing the composite substrate in a next time.

Surface processing is performed on the surface that is of the silicon carbide layer 11 in the second composite structure Q2 and that is away from the bearer layer 30, to remove the damaged layer 21. Roughness at the surface of the silicon carbide layer 11 is less than or equal to 0.5 nm, to obtain the third composite structure Q3.

For example, dry polishing is performed on the surface by using an 8000# grinding wheel, so that the roughness at the surface reaches 10 nm. Then, the surface is ground through CMP, so that the roughness at the surface of the silicon carbide layer 11 is less than or equal to 0.5 nm.

A 20 nm carbon protective film 50 is formed through sputtering on the surface that is of the silicon carbide layer 11 and that is away from the bearer layer 30. Then, in a vacuum environment and a 1200°C annealing environment, the carbon protective film 50 is annealed for 60 min and then is taken out of the furnace. Afterwards, the carbon protective film 50 is fully etched by using oxygen-containing plasma.

Then, the AlN epitaxial layer and the GaN epitaxial layer are sequentially epitaxially grown on the surface that is of the silicon carbide layer 11 and that is away from the bearer layer 30 to form the composite substrate 100.

Alternatively, the preparation method of a composite substrate includes:
Hydrogen ions are injected to the back surface of the non-conductive 6H monocrystal silicon carbide ingot 10 in the <0001> lattice direction. The defect layer 20 is formed at a position of the preset depth X of the back surface.

The temperature of the hydrogen ion injection is a room temperature. The energy of the hydrogen ion injection is 200 keV. The dose of the hydrogen ion injection is 1e17 cm². The angle of the hydrogen ion injection is 7°.

Chemical liquid cleaning and drying are performed on the back surface of the monocrystal silicon carbide ingot 10 and a Si₃N₄ substrate (the bearer layer 30). Then, plasma activation is performed on the back surface a1 of the monocrystal silicon carbide ingot 10 and the Si₃N₄ substrate by using Ar, N₂, O₂ (oxygen), or the like. Afterwards, the back surface a1 of the monocrystal silicon carbide ingot 10 is directly bonded to the Si₃N₄ substrate in a N₂ environment at a room temperature. The first composite structure Q1 is formed.

Bonding pressure is 15 kN. A bonding time is 180 min.

The first composite structure Q1 is placed in a high-temperature annealing furnace. In a N₂ protection environment, the first composite structure Q1 is annealed at an annealing temperature of 1100°C for 60 min in a fast thermal annealing manner through laser heating, and then is cooled and taken out of the furnace. The monocrystal silicon carbide ingot 10 is automatically peeled off along the defect layer 20 to form the second composite structure Q2.

Dry polishing is performed on the surface by using an 8000# grinding wheel, so that the roughness at the surface reaches 10 nm. Then, the surface is ground through CMP, so that the roughness at the surface of the silicon carbide layer 11 is less than or equal to 0.5 nm.

A 20 nm carbon protective film 50 is formed through sputtering on the surface that is of the silicon carbide layer 11 and that is away from the bearer layer 30. Then, in an annealing environment filled with a CH4/Ar mixed gas, the carbon protective film 50 is annealed at an annealing temperature of 1350°C for 30 min and then is taken out of the furnace. Afterwards, the carbon protective film 50 is fully etched by using oxygen-containing plasma, to form a composite substrate meeting epitaxial growth.

Then, the AlN epitaxial layer and the GaN epitaxial layer are sequentially epitaxially grown on the surface that is of the silicon carbide layer 11 and that is away from the bearer layer 30 to form the composite substrate 100.

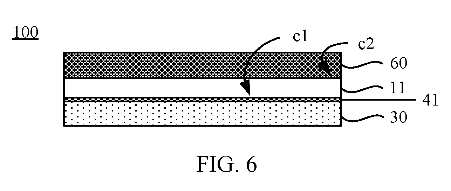

On this basis, as shown in FIG. 6, an embodiment of this application provides the composite substrate 100, including: the silicon carbide layer 11, the bearer layer 30, and the at least one epitaxial layer 60 (FIG. 6 shows one epitaxial layer 60).

The silicon carbide layer 11 is prepared by using the monocrystal silicon carbide ingot 10. The material of the silicon carbide layer 11 includes monocrystal silicon carbide. Alternatively, it is understood that the silicon carbide layer 11 is a monocrystal silicon carbide wafer.

The bearer layer 30 is disposed on a side of the back surface c1 of the silicon carbide layer 11. The silicon carbide layer 11 is disposed on the bearer layer 30. The back surface c1 of the silicon carbide layer 11 faces the bearer layer 30. The back surface c1 of the silicon carbide layer 11 is bonded to the bearer layer 30. In other words, the silicon carbide layer 11 is bonded to the bearer layer 30.

In some embodiments, as shown in FIG. 6, the back surface c1 of the monocrystal silicon carbide ingot 11 is bonded to the bearer layer 30 in direct contact. The back surface c1 of the silicon carbide layer 11 is bonded to the bearer layer 30 in direct contact to form the first bonding layer 41.

The at least one epitaxial layer 60 is disposed on a side that is of the silicon carbide layer 11 and that is away from the bearer layer 30.

### Example 2

A difference between Example 1 and Example 2 is that the silicon carbide layer 11 is bonded to the bearer layer 30 by using a transition layer 42.

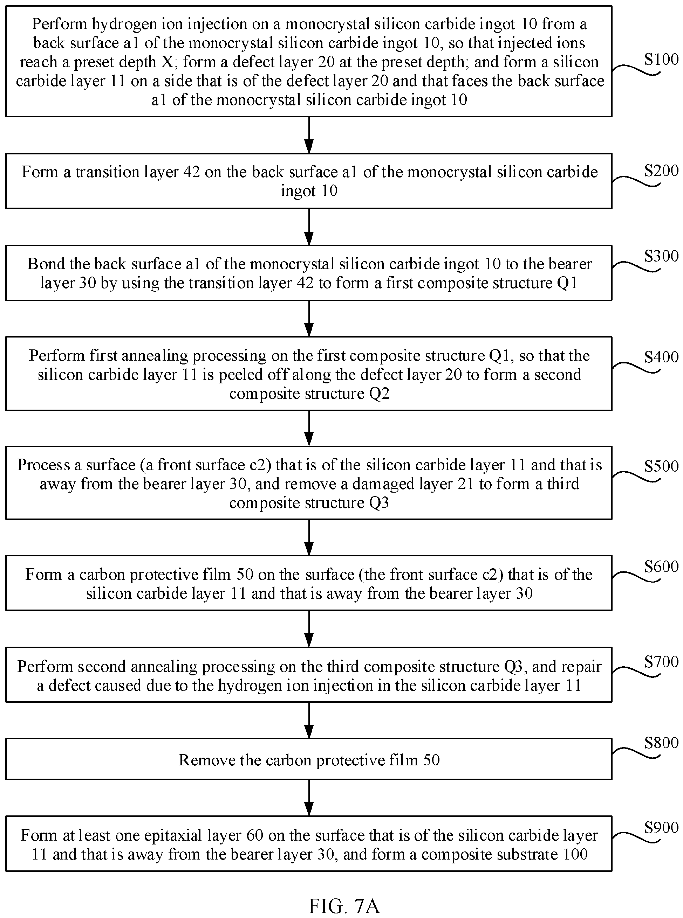

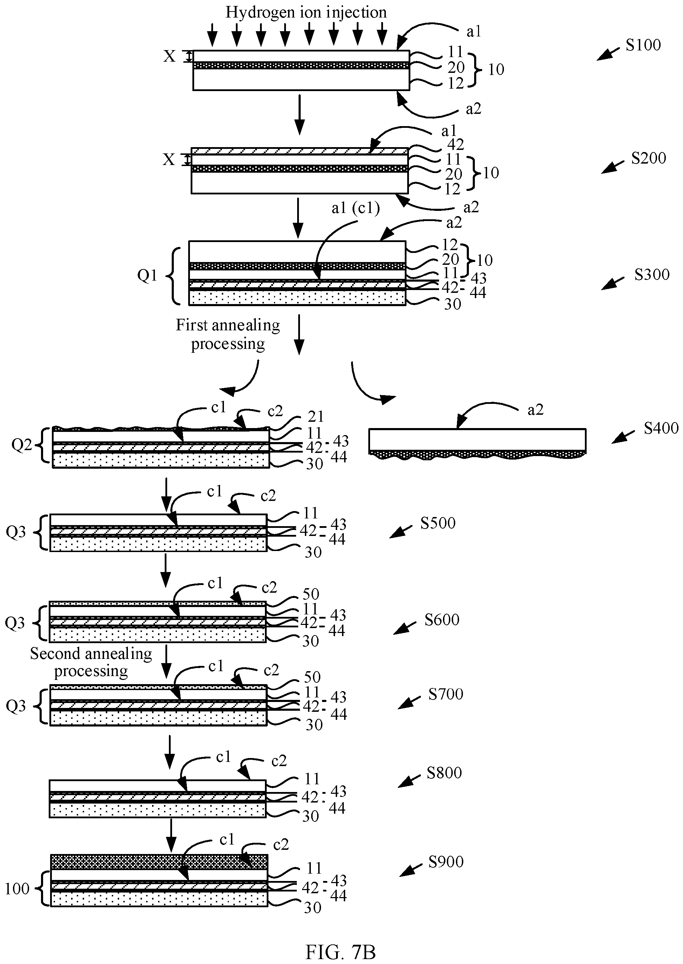

As shown in FIG. 7A, an embodiment of this application further provides a preparation method of a composite substrate. The method includes the following steps:
S100: As shown in FIG. 7B, perform hydrogen ion injection on a monocrystal silicon carbide ingot 10 from a back surface a1 of the monocrystal silicon carbide ingot 10, so that injected ions reach a preset depth X; form a defect layer 20 at the preset depth; and form a silicon carbide layer 11 on a side that is of the defect layer 20 and that faces the back surface a1 of the monocrystal silicon carbide ingot 10.

In other words, a part, in the monocrystal silicon carbide ingot 10, located on a side that is of the defect layer 20 and that faces the back surface a1 of the monocrystal silicon carbide ingot 10 is used as the silicon carbide layer 11.

Step S100 may be the same as step S10 in Example 1. Reference may be made to the foregoing related descriptions. Details are not described herein again.

S200: As shown in FIG. 7B, form a transition layer 42 on the back surface a1 of the monocrystal silicon carbide ingot 10.

Alternatively, step S200 is not performed, and step S200' is performed.

Alternatively, step S200 is performed, and step S200' is performed.

S200': Form a transition layer 42 on a bearer layer 30.

For example, the transition layer 42 may be formed by a sputtering process.

A material of the transition layer 42 may include, for example, an insulating medium such as SiO₂ (silicon oxide), Si₃N₄ (silicon nitride), or Al₂O₃ (aluminum oxide); or a conductive medium such as Si (silicon) or SiC (silicon carbide); or a metal such as A1 (aluminum), Cu (copper), Pt (platinum), Ni (nickel), Ti (titanium), Au (gold), and Cr (chromium); or a composite multi-layer material including the foregoing plurality of materials.

S300: As shown in FIG. 7B, bond the back surface a1 of the monocrystal silicon carbide ingot 10 to the bearer layer 30 by using the transition layer 42 to form a first composite structure Q1.

A second bonding layer 43 is naturally formed in a process of bonding the back surface a1 of the monocrystal silicon carbide ingot 10 to the transition layer 42. A third bonding layer 44 is naturally formed in a process of bonding the bearer layer 30 to the transition layer 42.

On this basis, it may be understood that the first composite structure Q1 includes the monocrystal silicon carbide ingot 10, the second bonding layer 43, the transition layer 42, the third bonding layer 44, and the bearer layer 30.

In some embodiments, a sum of a thickness of the transition layer 42, a thickness of the second bonding layer 43, and a thickness of the third bonding layer 44 is less than or equal to 100 nm. For example, the sum of the thickness of the transition layer 42, the thickness of the second bonding layer 43, and the thickness of the third bonding layer 44 is 90 nm, 80 nm, 70 nm, or 60 nm.

An excessively large sum of the thickness of the transition layer 42, the thickness of the second bonding layer 43, and the thickness of the third bonding layer 44 affects thermal conductivity of the composite substrate. Therefore, the sum of the thickness of the transition layer 42, the thickness of the second bonding layer 43, and the thickness of the third bonding layer 44 is controlled to be less than or equal to 100 nm, to reduce the sum of the thickness of the transition layer 42, the thickness of the second bonding layer 43, and the thickness of the third bonding layer 44 as much as possible on the basis of ensuring that the back surface a1 of the monocrystal silicon carbide ingot 10 is steadily bonded to the bearer layer 30.

It can be learned from the description of Example 1 that the sum of the thickness of the transition layer 42, the thickness of the second bonding layer 43, and the thickness of the third bonding layer 44 may be controlled through controlling a time in which the back surface a1 of the monocrystal silicon carbide ingot 10 is bonded to the bearer layer 30.

S400: As shown in FIG. 7B, perform first annealing processing on the first composite structure Q1, so that the silicon carbide layer 11 is peeled off along the defect layer 20 to form a second composite structure Q2.

For a process of performing the first annealing processing on the first composite structure Q1, refer to the description of step S30 in Example 1. A difference is that the obtained second composite structure Q2 includes a damaged layer 21 obtained through separation from the defect layer 20, and the silicon carbide layer 11, the transition layer 42, and the bearer layer 30 that are bonded.

S500: As shown in FIG. 7B, process a surface (a front surface c2) that is of the silicon carbide layer 11 and that is away from the bearer layer 30, and remove the damaged layer 21 to form a third composite structure Q3.

For a process of processing the front surface c2 of the silicon carbide layer 11, refer to the description of step S40 in Example 1. A difference is that the obtained third composite structure Q3 includes the silicon carbide layer 11, the transition layer 42, and the bearer layer 30 that are bonded.

S600: As shown in FIG. 7B, form a carbon protective film 50 on the surface (the front surface c2) that is of the silicon carbide layer 11 and that is away from the bearer layer 30.

Step S600 may be the same as step S50 in Example 1. Reference may be made to the related descriptions. Details are not described herein again.

S700: As shown in FIG. 7B, perform second annealing processing on the third composite structure Q3, and repair a defect caused due to the hydrogen ion injection in the silicon carbide layer 11.

Step S700 may be the same as step S60 in Example 1. Reference may be made to the related descriptions. Details are not described herein again.

S800: As shown in FIG. 7B, remove the carbon protective film 50.

Step S800 may be the same as step S70 in Example 1. Reference may be made to the related descriptions. Details are not described herein again.

S900: As shown in FIG. 7B, form at least one epitaxial layer 60 on the surface that is of the silicon carbide layer 11 and that is away from the bearer layer 30, and form a composite substrate 100.

Step S900 may be the same as step S80 in Example 1. Reference may be made to the related descriptions. Details are not described herein again. A difference is that the obtained composite substrate further includes the transition layer 42, and the transition layer 42 is located between the back surface a1 of the silicon carbide layer 11 and the bearer layer 30.

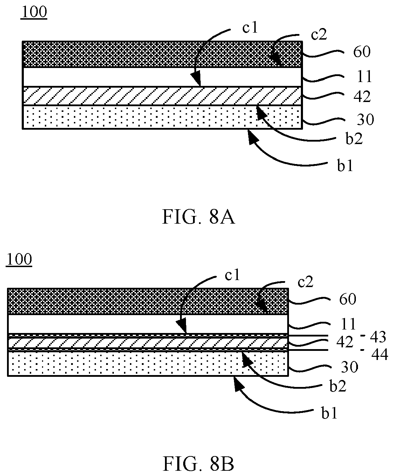

On this basis, as shown in FIG. 8A, an embodiment of this application provides the composite substrate 100, including: the silicon carbide layer 11, the transition layer 42, the bearer layer 30, and the at least one epitaxial layer 60 (FIG. 8A shows one epitaxial layer 60).

The transition layer 42 is located between the back surface a1 of the silicon carbide layer 11 and the bearer layer 30. The silicon carbide layer 11 is bonded to the bearer layer 30 by using the transition layer 42.

For example, as shown in FIG. 8B, the silicon carbide layer 11 is bonded to the transition layer 42 to form the second bonding layer 43, and the bearer layer 30 is bonded to the transition layer 42 to form the third bonding layer 44.

In the preparation method of a composite substrate provided in this embodiment of this application, the hydrogen ion injection is performed on the monocrystal silicon carbide ingot 10 to form the defect layer 20. Then, the monocrystal silicon carbide ingot 10 is bonded to the bearer layer 30. The bonded composite structure is annealed at a high temperature, to form a composite structure including the bearer layer 30 and the silicon carbide layer 11, and the remaining monocrystal silicon carbide ingot 12. The remaining monocrystal silicon carbide ingot 12 after being polished may be still used as the monocrystal silicon carbide ingot 10. After surface polishing and high-temperature annealing are performed on the composite structure, one or more epitaxial layers 60 (III-V nitride) are formed on the surface that is of the silicon carbide layer 11 and that is away from the bearer layer 30, to form the AlₓGa_{y}N composite substrate 100.

In the preparation method of a composite substrate provided in the embodiments of this application, the monocrystal silicon carbide ingot 10 is cut in a hydrogen ion injection manner, to effectively reduce a cutting loss and improve a yield and cutting efficiency. In addition, the remaining monocrystal silicon carbide ingot 12 after being polished may be still used as the monocrystal silicon carbide ingot 10. Therefore, in comparison with a monocrystal GaN substrate and a monocrystal SiC substrate, the composite substrate prepared by using the preparation method of a composite substrate provided in the embodiments of this application can improve utilization of the silicon carbide ingot and reduce the costs.

In addition, a surface of the composite substrate 100 provided in this embodiment of this application includes the epitaxial layer 60 (III-V nitride). In comparison with another film layer grown on a non-monocrystal SiC substrate in a semiconductor device, when the another film layer in the semiconductor device is grown on the epitaxial layer 60 of the composite substrate 100 provided in the embodiments of this application, the silicon carbide layer 11 and the epitaxial layer 60 have a small lattice mismatch and a small thermal mismatch. Therefore, when the another film layer is grown on the epitaxial layer 60, epitaxial defect density is small, to meet a high-quality further epitaxy manufacturing requirement and a manufacturing requirement of the semiconductor device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A composite substrate, comprising:
a bearer layer;
a silicon carbide layer, disposed on the bearer layer and bonded to the bearer layer, wherein a material of the silicon carbide layer comprises monocrystal silicon carbide; and
at least one epitaxial layer, disposed on a side that is of the silicon carbide layer and that is away from the bearer layer.

2. The composite substrate according to claim 1, wherein the silicon carbide layer is bonded to the bearer layer in direct contact.

3. The composite substrate according to claim 2, wherein a thickness of a first bonding layer formed through bonding between the silicon carbide layer and the bearer layer in direct contact is less than or equal to 5 nm.

4. The composite substrate according to claim 1, wherein the composite substrate further comprises a transition layer, the transition layer is located between the silicon carbide layer and the bearer layer, and the silicon carbide layer and the bearer layer are separately bonded to the transition layer.

5. The composite substrate according to claim 4, wherein the silicon carbide layer is bonded to the transition layer to form a second bonding layer, and the bearer layer is bonded to the transition layer to form a third bonding layer; and
a sum of a thickness of the transition layer, a thickness of the second bonding layer, and a thickness of the third bonding layer is less than or equal to 100 nm.

6. The composite substrate according to any one of claims 1 to 5, wherein a material of the epitaxial layer comprises III-V nitride.

7. The composite substrate according to any one of claims 1 to 5, wherein the material of the silicon carbide layer comprises 4H silicon carbide or 6H silicon carbide.

8. The composite substrate according to any one of claims 1 to 5, wherein a melting point of a material of the bearer layer is greater than or equal to 1260°C.

9. The composite substrate according to any one of claims 1 to 5, wherein a thickness of the silicon carbide layer is less than or equal to 350 µm;
a thickness of the bearer layer is less than or equal to 3000 µm;
and/or
a thickness of the at least one epitaxial layer is less than or equal to 3000 µm.

10. A preparation method of a composite substrate, comprising:
performing hydrogen ion injection on a monocrystal silicon carbide ingot from a back surface of the monocrystal silicon carbide ingot, so that injected ions reach a preset depth, forming a defect layer at the preset depth, and forming a silicon carbide layer on a side that is of the defect layer and that faces the back surface of the monocrystal silicon carbide ingot;
bonding the back surface of the monocrystal silicon carbide ingot to a bearer layer to form a first composite structure;
performing first annealing processing on the first composite structure, so that the silicon carbide layer is peeled off along the defect layer to form a second composite structure, wherein the second composite structure comprises a damaged layer obtained through separation from the defect layer, and the silicon carbide layer and the bearer layer that are bonded to each other;
performing surface processing on a surface that is of the silicon carbide layer and that is away from the bearer layer, and removing the damaged layer to form a third composite structure;
performing second annealing processing on the third composite structure, and repairing a defect caused due to the hydrogen ion injection in the silicon carbide layer, wherein an annealing temperature of the second annealing processing is greater than a temperature of the first annealing processing; and
forming at least one epitaxial layer on the surface that is of the silicon carbide layer and that is away from the bearer layer to form the composite substrate.

11. The preparation method of the composite substrate according to claim 10, wherein before the performing second annealing processing on the third composite structure, the preparation method further comprises:
forming a carbon protective film on the surface that is of the silicon carbide layer and that is away from the bearer layer; and
before the forming at least one epitaxial layer on the surface that is of the silicon carbide layer and that is away from the bearer layer, the preparation method further comprises: removing the carbon protective film.

12. The preparation method of the composite substrate according to claim 10, wherein the bonding the back surface of the monocrystal silicon carbide ingot to a bearer layer comprises:
forming a transition layer on the back surface of the monocrystal silicon carbide ingot or the bearer layer; and
bonding the back surface of the monocrystal silicon carbide ingot and the bearer layer by using the transition layer, wherein
the composite substrate further comprises the transition layer located between the silicon carbide layer and the bearer layer.

13. A semiconductor device, comprising the composite substrate according to any one of claims 1 to 9 and a heterojunction, wherein the heterojunction is disposed on a side that is of at least one epitaxial layer of the composite substrate and that is away from the bearer layer.

14. An electronic device, comprising the semiconductor device according to claim 13 and an antenna, wherein the semiconductor device is configured to amplify a radio frequency signal and output the amplified radio frequency signal to the antenna for external radiation.

15. An electronic device, comprising the semiconductor device according to claim 13 and a printed circuit board, wherein the semiconductor device is coupled to the printed circuit board; and
a material of a bearer layer in the semiconductor device is a conductive material.
